## Europäisches Patentamt

## European Patent Office

## Office européen des brevets

(11) **EP 1 480 339 A1**

(12) **EUROPÄISCHE PATENTANMELDUNG**

(43) Veröffentlichungstag:
**24.11.2004 Patentblatt 2004/48**

(51) Int Cl.$^7$: **H03K 17/16**

(21) Anmeldenummer: **03405343.9**

(22) Anmeldetag: **19.05.2003**

(84) Benannte Vertragsstaaten:
**AT BE BG CH CY CZ DE DK EE ES FI FR GB GR HU IE IT LI LU MC NL PT RO SE SI SK TR**
Benannte Erstreckungsstaaten:
**AL LT LV MK**

(71) Anmelder: **ABB Technology AG**
**8050 Zürich (CH)**

(72) Erfinder:
• **Schlapbach, Ulrich**
**3013 Bern (CH)**

• **Schnell, Raffael**
**5703 Seon (CH)**

(74) Vertreter: **ABB Patent Attorneys**
**c/o ABB Schweiz AG,**
**Intellectual Property (CH-LC/IP),**
**Brown Boveri Strasse 6**
**5400 Baden (CH)**

(54) **Halbleiterschalteranordnung**

(57) Bei einer elektronischen Schaltung, umfassend eine Ansteuereinheit (20), welche mindestens ein Ansteuersignal erzeugt, zwei oder mehrere durch das Ansteuersignal synchron schaltbare Leistungshalbleiterschalter ($T_1$, $T_2$, $T_3$) mit je einem ersten und einem zweiten Hauptanschluss, wobei die ersten und die zweiten Hauptanschlüsse der Leistungshalbleiterschalter ($T_1$, $T_2$, $T_3$) jeweils untereinander elektrisch parallel geschaltet sind, für jeden der Leistungshalbleiterschalter ($T_1$, $T_2$, $T_3$) eine erste und eine zweite elektrisch leitende Verbindung zum Anschluss an die Ansteuereinheit (20), wird eine gleichmässige dynamische Stromaufteilung auf die Leistungshalbleiterschalter ($T_1$, $T_2$, $T_3$) erfindungsgemäss dadurch erreicht, dass in jeder der ersten elektrisch leitenden Verbindungen eine erste Induktivität vorgesehen ist und in jeder der zweiten elektrisch leitenden Verbindungen eine zweite Induktivität vorgesehen ist, wobei für jeden der Leistungshalbleiterschalter die erste Induktivität mit der zweiten Induktivität gekoppelt ist.

Fig. 2

**Beschreibung**

**Technisches Gebiet**

Die vorliegende Erfindung bezieht sich auf das Gebiet der Leistungselektronik. Sie betrifft eine elektronische Schaltung und ein Leistungshalbleitermodul nach dem Oberbegriff von Patentanspruch 1 bzw. 7.

**Stand der Technik**

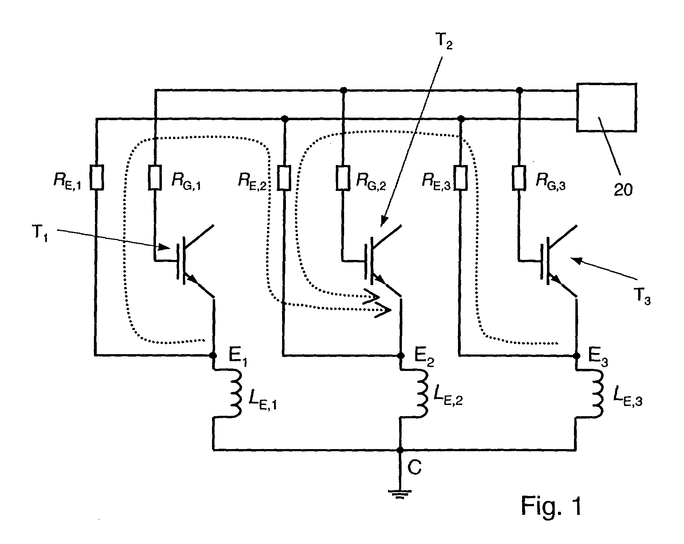

In gängigen Leistungshalbleitermodulen sind häufig zwei oder mehrere, im Allgemeinen identische, Leistungshalbleiterschalter parallel geschaltet, um eine gewünschte Gesamtstromkapazität zu erreichen. Dabei muss gewährleistet sein, dass ein durch das Leistungshalbleitermodul fliessender Gesamtstrom zu jedem Zeitpunkt möglichst gleichmässig auf die einzelnen Leistungshalbleiterschalter verteilt wird, um zu verhindern, dass eine Stromkapazität eines einzelnen Leistungshalbleiterschalters überschritten wird. Kritisch sind in diesem Zusammenhang insbesondere Schaltvorgänge, da während dieser eine Rückwirkung von Ausgangsseiten auf Ansteuerseiten der Leistungshalbleiterschalter zu einer ungleichmässigen dynamischen Stromaufteilung führen kann. Dies wird im Folgenden anhand von Fig. 1 erläutert. Fig. 1 zeigt ein Schaltbild eines Leistungshalbleitermoduls mit drei parallel geschalteten Leistungshalbleiterschaltern nach dem Stand der Technik, welches sich zum Beispiel bei einem asymmetrischen Layout dreier bipolarer Transistoren $T_1$, $T_2$ und $T_3$ mit isoliertem Gate (IGBT) ergibt. Parasitäre emitterseitige Induktivitäten $L_{E,1}$, $L_{E,2}$ und $L_{E,3}$ haben dabei aufgrund unterschiedlicher Geometrien entsprechender elektrisch leitender Verbindungen zwischen jeweiligem Emitteranschluss $E_1$, $E_2$ bzw. $E_3$ und einem Knoten C unterschiedliche Werte. Bei einem Schaltvorgang werden aufgrund der unterschiedlichen Werte der Induktivitäten $L_{E,1}$, $L_{E,2}$ und $L_{E,3}$ unterschiedliche Spannungen über diesen induziert. Im vorliegenden Fall mit $L_{E,1} = L_{E,3} > L_{E,2}$ resultiert daraus ein dynamischer Kreisstrom, d.h. ein Stromfluss von Emitteranschluss $E_1$ bzw. $E_3$ zu Emitteranschluss $E_2$, wie in der Fig. 1 durch gestrichelte Pfeile dargestellt ist. Dieser Stromfluss erzeugt wiederum unterschiedliche Spannungsabfälle $U_{R,1}$, $U_{R,2}$ und $U_{R,3}$ über Emitterwiderständen $R_{E,1}$, $R_{E,2}$ und $R_{E,3}$, und somit unterschiedliche Gatespannungen $U_{G,1}$, $U_{G,2}$ und $U_{G,3}$ an den IGBTs $T_1$, $T_2$, $T_3$. Die unterschiedlichen Gatespannungen $U_{G,1}$, $U_{G,2}$ und $U_{G,3}$ bewirken schliesslich Schwingungen, Kreisströme und die erwähnte ungleichmässige dynamische Stromaufteilung, was zu einer Reduktion einer Schaltleistung gegenüber einem theoretisch möglichen Wert führt (engl. "derating").

Verschiedene Methoden sind bekannt, mit denen dieser ungleichmässigen dynamischen Stromaufteilung entgegengewirkt werden kann.

Zunächst kommt eine getrennte Ansteuerung in Verbindung mit einer ausgangsseitigen Entkopplung mittels zusätzlicher induktiver oder resistiver Bauelemente, durch welche die unterschiedlichen Werte der Induktivitäten $L_{E,1}$, $L_{E,2}$ und $L_{E,3}$ ausgeglichen werden, in Frage. Eine solche Lösung führt jedoch zu einem erhöhten Platzbedarf, bei grossen Strömen aufgrund von Anforderungen an die Bauelemente auch zu erhöhten Kosten.

Denkbar ist auch jeweils eine harte, direkte Verbindung sowohl der Ausgangsseiten als auch der Ansteuerseiten, wobei die Ansteuerseiten vorzugsweise mittels Entkopplungswiderständen entkoppelt werden. Falls eine stationäre wie dynamische Symmetrie erreicht werden kann, ist dies eine brauchbare und kostengünstige Lösung. Da dies jedoch im Allgemeinen insbesondere eine geometrische Symmetrie der Leistungshalbleitermodule oder zumindest eine untereinander identische oder spiegelverkehrte Ausführung von Ansteuer- und Leistungszuleitungen erforderlich macht, ist ein derartiges Vorgehen bei Leistungshalbleitermodulen mit mehr als zwei Leistungshalbleiterschaltern im allgemeinen nicht oder höchstens unter grossem Aufwand anwendbar. Auch ist die beschriebene Lösung im Allgemeinen nicht anwendbar, wenn Leistungshalbleiterschalter, die sich in getrennten Submodulen befinden, oder gar komplette Leistungshalbleitermodule, parallel geschaltet werden sollen.

Eine weitere Variante verwendet ebenfalls die harte, direkte Verbindung der Ausgangsseiten, entkoppelt jedoch die Ansteuerseiten durch eine Verwendung getrennter Ansteuereinheiten. Dies stellt jedoch im Hinblick auf Synchronizität und Affinität der Ansteuereinheiten hohe Anforderungen, was wiederum zu erhöhten Herstellungskosten führt.

**Darstellung der Erfindung**

Es ist somit Aufgabe der Erfindung, eine elektronische Schaltung mit mindestens zwei parallel geschalteten Leistungshalbleiterschaltern anzugeben, bei welcher eine möglichst gleichmässige dynamische Stromaufteilung auf die mindestens zwei Leistungshalbleiterschalter erreicht wird.

Diese und weitere Aufgaben werden durch eine elektronische Schaltung der eingangs genannten Art mit den Merkmalen des unabhängigen Patentanspruchs gelöst. Weitere vorteilhafte Ausgestaltungen der Erfindung sind in den abhängigen Ansprüchen angegeben.

Bei der erfindungsgemässen elektronischen Schaltung ist in jeder von jeweils zwei Zuleitungen zwischen einer Steuereinheit und je einem von mindestens zwei von der Steuereinheit angesteuerten Leistungshalbleiterschaltern eine Induktivität vorgesehen, wobei jeweils die beiden Induktivitäten miteinander gekoppelt sind, die sich in den zwei Zuleitungen zum selben Leistungshalbleiterschalter befinden.

Durch die gekoppelten Induktivitäten werden Kopplungs- und Übersprechprobleme während Schaltvorgängen reduziert. Dynamische Kreisströme werden minimiert und Schwingungen zwischen den Leistungshalbleiterschaltern werden wirkungsvoll unterdrückt. Die erfindungsgemässe elektronische Schaltung weist sowohl die Vorzüge direkt parallelgeschalteter Ausgangsseiten als auch die Vorzüge einer separaten Ansteuerung der Leistungshalbleiterschalter auf, ohne dass eine Synchronisation mehrerer getrennter Steuereinheiten oder eine kostspielige Beschaltung im Ausgangskreis notwendig wäre, was eine kostengünstige Herstellung ermöglicht. Eine Symmetrisierung der Ausgangsseiten kann auf ein Gleichstromverhalten optimiert werden, insbesondere durch eine gleichmässige Aufteilung eines Gatewiderstands auf Gate und Emitter der Leistungshalbleiterschalter.

Diese und weitere Aufgaben, Vorteile und Merkmale der Erfindung werden aus der nachfolgenden, detaillierten Beschreibung eines bevorzugten Ausführungsbeispiels der Erfindung in Verbindung mit der Zeichnung offensichtlich.

**Kurze Beschreibung der Zeichnung**

Fig. 1 zeigt eine elektronische Schaltung mit drei parallel geschalteten Leistungshalbleiterschaltern nach dem Stand der Technik.

Fig. 2 zeigt eine erfindungsgemässe elektronische Schaltung.

Fig. 3a zeigt ein Schaltbild einer Messanordnung zur Messung einer Reihen-Induktivität einer Gleichtaktunterdrückungsdrossel $D_i$.

Fig. 3b zeigt ein Schaltbild einer Messanordnung zur Messung einer Gleichtakt-Induktivität einer Gleichtaktunterdrückungsdrossel $D_i$.

Fig. 4 zeigt eine bevorzugte Ausgestaltung einer erfindungsgemässen elektronischen Schaltung.

Die in der Zeichnung verwendeten Bezugszeichen und deren Bedeutung sind in der Bezugszeichenliste zusammengefasst. Grundsätzlich bezeichnen gleiche Bezugszeichen gleiche Teile.

**Wege zur Ausführung der Erfindung**

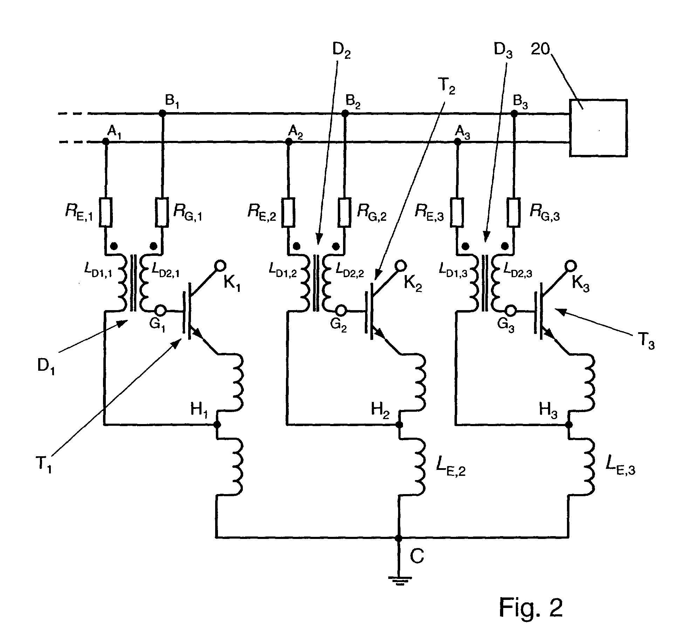

Fig. 2 zeigt eine erfindungsgemässe elektronische Schaltung mit drei parallel geschalteten IGBTs $T_i$, mit $i \in$ {1,2,3}, als Leistungshalbleiterschalter. Diese sind mittels einer gemeinsamen Ansteuereinheit 20 synchron schaltbar. Zu diesem Zweck ist jedem der IGBTs $T_i$ über je ein Ansteuerzuleitungspaar ein von der gemeinsamen Ansteuereinheit erzeugtes Ansteuersignal zuführbar. Jedes Ansteuerzuleitungspaar umfasst eine erste Ansteuerzuleitung, welche zwischen Knoten $A_i$ und Hilfsemitteranschluss $H_i$ vorgesehen ist, und eine zweite Ansteuerzuleitung, welche zwischen Knoten $B_i$ und Gateanschluss $G_i$ vorgesehen ist. Erfindungsgemäss ist in jedem der Ansteuerzuleitungspaare je eine Gleichtaktunterdrückungsdrossel $D_i$ vorgesehen. Durch die Gleichtaktunterdrückungsdrosseln $D_i$ werden die Ansteuerzuleitungspaare von einem Leistungskreis entkoppelt, welcher durch die IGBTs $T_i$ zwischen Kathodenanschlüssen $K_i$ und einem gemeinsamen Knoten C verläuft. Durch die Entkopplung wird eine gleichmässige dynamische Stromaufteilung auf Pfade $K_1$-C, $K_2$-C und $K_3$-C im Leistungskreis gewährleistet. Vorzugsweise wird dabei ein Gatewiderstand so aufgeteilt, dass für i $\in$ {1,2,3} $R_{G,i} \approx R_{E,i}$ gilt, wobei vorzugsweise für $R_{G,i}$ und $R_{E,i}$ ein Wert des halben Nenngatewiderstandes $R_{G,nom}$ des IGBTs, d.h. $R_{G,i} = R_{E,i} = \frac{1}{2} R_{G,nom}$ gewählt wird.

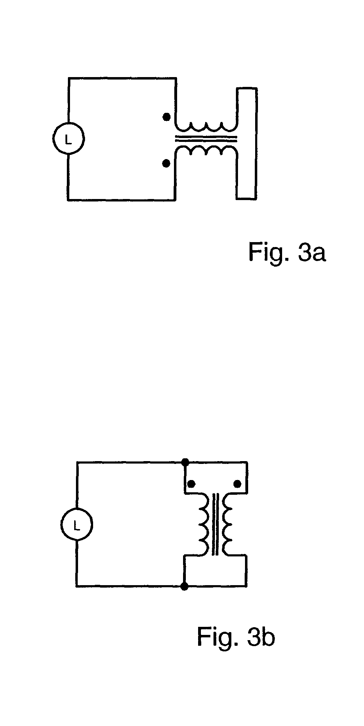

Reihen-Induktivitäten $L_{D,i}^{(S)}$ der Gleichtaktunterdrückungsdrosseln $D_i$ werden dabei vorzugsweise so klein wie möglich, vorzugsweise kleiner oder gleich 200nH gewählt. Die Reihen-Induktivität der Gleichtaktunterdrückungsdrossel $D_i$ ist dabei diejenige Induktivität, die gemessen wird, wenn beide Windungen der Gleichtaktunterdrückungsdrossel $D_i$ in Serie geschaltet sind. Fig. 3a zeigt ein Schaltbild einer Messanordnung zur Messung der Reihen-Induktivität der Gleichtaktunterdrückungsdrossel $D_i$.

Gleichtakt-Induktivitäten $L_{D,i}^{(G)}$ der Gleichtaktunterdrückungsdrosseln $D_i$ werden dabei vorzugsweise zumindest annähernd wie folgt gewählt: Ausgehend von einem Maximum $\Delta L_E$ der Differenzen $L_{E,i}$ - - $L_{E,j}$ zwischen zwei Emitterinduktivitäten mit $i{\neq}j \in \{1,2,3\}$ und einer vorgegebenen, maximal zulässigen Differenz $\Delta U_{GE}$ zwischen zwei Gate-Emitterspannugen $U_{GE,i}$, und $U_{GE,j}$, welche zwischen Hilfsemitteranschlüssen $H_i$ bzw. $H_j$ und Gateanschlüssen $G_i$ bzw. $G_j$ zweier IGBTs $T_i$ bzw. $T_j$ mit $i{\neq}j \in \{1,2,3\}$ anliegen, lässt sich eine minimale Gleichtakt-Induktivität $L_D^{(G)}$ berechnen. Da die IGBTs $T_i$ spannungsgesteuerte Bauelemente sind, bei welchen ein Kollektorstrom über die Gate-Emitterspannug $U_{GE,i}$ eingestellt werden kann, muss die maximal zulässige Spannungsdifferenz $\Delta U_{GE}$ über einen maximal zulässigen Kollektorstromunterschied in einem interessierenden Bereich aus einer Transfercharakteristik der IGBTs $T_i$ ausgelesen werden.

Eine zulässige Differenz einer Gateladung $\Delta Q_{GE}$ ergibt sich durch Multiplikation der maximal zulässige Spannungsdifferenz $\Delta U_{GE}$ mit einer Gate-Emitterkapazität $C_{GE}$ gemäss

$$\Delta Q_{GE} = \Delta V_{GE} \cdot C_{GE} \, ,$$

wobei angenommen wurde, dass die Gate-Emitterkapazität $C_{GE,i}$ für alle drei IGBTs $T_i$ den gleichen Wert $C_{GE}$ aufweist.

Ein maximal zulässiger Unterschied $\Delta I_G$ zwischen Gateströmen $I_i$ und $I_j$ mit $i{\neq}j \in \{1,2,3\}$ kann dann errechnet werden, indem die maximal zulässige Differenz der Gateladung $\Delta Q_{GE}$ durch eine relevante Zeit $t_R$, während welcher sich die Spannung über den unterschiedlichen Emitterinduktivitäten aufbaut geteilt wird, das heisst

$$\Delta I_G = \frac{\Delta Q_{GE}}{t_R}.$$

Für die minimale Gleichtakt-Induktivität $L_D^{(G)}$ ergibt sich somit, wenn eine Spannungszeitfläche über der Differenz der Emitterinduktivitäten durch den zulässigen Gatestromunterschied geteilt wird:

$$L_D^{(G)} = \frac{U}{\Delta I_G / \Delta t} = \frac{U \cdot \Delta t}{\Delta I_G}.$$

Die Spannungszeitfläche über dem Maximum $\Delta L_E$ der Differenzen der Emitterinduktivitäten $L_{E,i}$ - $L_{E,j}$ kann durch Multiplikation von $\Delta L_E$ mit einem grösst möglichen Strom, dem Kurzschlussstrom $I_{sc}$ der IGBTs, errechnet werden:

$$U \cdot \Delta t = \Delta L_E \cdot I_{sc} \cdot$$

Somit ergibt sich

$$L_D^{(G)} = \frac{U}{\Delta I_G / dt} = \frac{\Delta L_E \cdot I_{sc}}{\Delta I_G}$$

Die Gleichtakt-Induktivität der Gleichtaktunterdrückungsdrosseln $D_i$ ist dabei diejenige Induktivität, die gemessen wird, wenn beide Windungen der Gleichtaktunterdrückungsdrossel $D_i$ parallel geschaltet sind. Fig. 3b zeigt ein Schaltbild einer Messanordnung zur Messung der Gleichtakt-Induktivität der Gleichtaktunterdrückungsdrossel $D_i$.

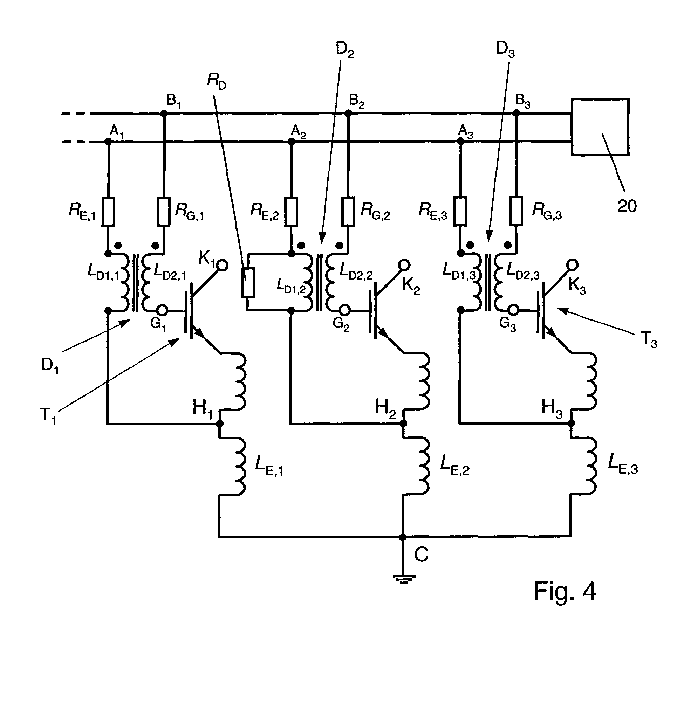

Fig. 4 zeigt eine bevorzugte Ausgestaltung der erfindungsgemässen elektronischen Schaltung. Dabei ist, zwischen den Knoten $A_2$ und den Hilfsemitteranschlüssen $H_2$ parallel zu der Gleichtaktunterdrückungsdrossel $D_2$ ein Widerstand $R_D$, vorgesehen, um Spitzenwerte $\hat{U}_D$ zwischen der Ansteuereinheit und dem Leistungskreis zu minimieren. Vorzugsweise wird für $R_D$ ein Wert von einigen Ohm bis zu einigen zehn Ohm gewählt.

Ein erfindungsgemässes Leistungshalbleitermodul umfasst ein Modulgehäuse an sich bekannter Art und eine elektronische Schaltung, wie sie in diesem Abschnitt beschrieben wurde. Vorzugsweise sind dabei sowohl die Leistungshalbleiterschalter wie auch die Ansteuereinheit und/oder die ersten und zweiten Induktivitäten im Modulgehäuse untergebracht. Vorteilhaft kann jedoch die Ansteuereinheit und/oder die ersten und zweiten Induktivitäten auch ausserhalb des Modulgehäuses vorgesehen, insbesondere angeschraubt oder angesteckt, sein.

In einer bevorzugten Weiterbildung des erfindungsgemässen Leistungshalbleitermoduls umfasst dieses zwei oder mehrere Submodule, und die mindestens zwei von der Steuereinheit angesteuerten Leistungshalbleiterschalter befinden sich nicht alle im selben Submodul. In diesem Fall kann die Erfindung besonders vorteilhaft eingesetzt werden, da eine untereinander identische oder spiegelverkehrte Ausführung von Ansteuer- und Leistungszuleitungen bei Leistungshalbleiterschaltern, welche sich in verschiedenen Submodulen befinden, im Allgemeinen nicht realisierbar ist und somit bekannte, im Stand der Technik beschriebene Behelfslösungen nicht zur Verfügung stehen.

**Bezugszeichenliste**

| | |
|---|---|
| 20 | Ansteuereinheit |
| $A_1$, $A_2$, $A_3$ | Knoten |
| $B_1$, $B_2$, $B_3$ | Knoten |
| $D_1$, $D_2$, $D_3$ | Gleichtaktunterdrückungsdrossel |
| $E_1$, $E_2$, $E_3$ | Emitteranschluss |
| $G_1$, $G_2$, $G_3$ | Gateanschluss |
| $H_1$, $H_2$, $H_3$ | Hilfsemitteranschluss |
| $K_1$, $K_2$, $K_3$ | Kathodenanschluss |
| $L_{D1,1}$, $L_{D1,2}$, $L_{D1,3}$ | Erste Induktivität |
| $L_{D2,1}$, $L_{D2,2}$, $L_{D2,3}$ | Zweite Induktivität |
| $R_D$ | Begrenzungswiderstand |
| $T_1$, $T_2$, $T_3$ | IGBT, Leistungshalbleiterschalter |

**Patentansprüche**

1. Elektronische Schaltung, insbesondere zur Verwendung als Leistungsschalter, umfassend

   - eine Ansteuereinheit (20), welche mindestens ein Ansteuersignal erzeugt,

   - zwei oder mehrere durch das Ansteuersignal synchron schaltbare Leistungshalbleiterschalter ($T_1$, $T_2$, $T_3$) mit je einem ersten und einem zweiten Hauptanschluss, wobei die ersten und die zweiten Hauptanschlüsse der Leistungshalbleiterschalter ($T_1$, $T_2$, $T_3$) jeweils untereinander elektrisch parallel geschaltet sind,

   - für jeden der Leistungshalbleiterschalter ($T_1$, $T_2$, $T_3$) eine erste und eine zweite elektrisch leitende Verbindung zum Anschluss an die Ansteuereinheit (20),

   **dadurch gekennzeichnet, dass**

   - in jeder der ersten elektrisch leitenden Verbindungen eine erste Induktivität ($L_{D1,1}$, $L_{D1,2}$, $L_{D1,3}$) vorgesehen ist,

   - in jeder der zweiten elektrisch leitenden Verbindungen eine zweite Induktivität ($L_{D2,1}$, $L_{D2,2}$, $L_{D2,3}$) vorgesehen ist,

   - für jeden der Leistungshalbleiterschalter die erste Induktivität ($L_{D1,1}$, $L_{D1,2}$, $L_{D1,3}$) mit der zweiten Induktivität ($L_{D2,1}$, $L_{D2,2}$, $L_{D2,3}$) gekoppelt ist.

2. Elektronische Schaltung nach Anspruch 1, **dadurch gekennzeichnet, dass**

   - für jeden der Leistungshalbleiterschalter ($T_1$, $T_2$, $T_3$) je eine Gleichtaktunterdrückungsdrossel ($D_1$, $D_2$, $D_3$) vorgesehen ist, wobei jeweils eine erste Wicklung der Gleichtaktunterdrückungsdrossel ($D_1$, $D_2$, $D_3$) die erste Induktivität ($L_{D1,1}$, $L_{D1,2}$, $L_{D1,3}$) bildet und eine zweite Wicklung der Gleichtaktunterdrückungsdrossel ($D_1$, $D_2$, $D_3$) die zweite Induktivität ($L_{D2,1}$, $L_{D2,2}$, $L_{D2,3}$) bildet.

3. Elektronische Schaltung nach einem der vorangehenden Ansprüche, **dadurch gekennzeichnet, dass**

   - für jede Gleichtaktunterdrückungsdrossel ($D_1$, $D_2$, $D_3$) eine Gleichtakt-Induktivität $L_{D,i}^{(G)}$ gewählt wird, die grösser ist als eine minimale Gleichtakt-Induktivität $L_D^{(G)}$ mit

$$L_{\mathrm{D}}^{(G)} = \frac{\Delta L_E \cdot I_{sc}}{\Delta I_G},$$

wobei

- $\Delta L_E$ ein maximale Differenz $L_{E,i}$ - $L_{E,j}$ zwischen zwei Emitterinduktivitäten $L_{E,i}$ und $L_{E,j}$ mit $i{\neq}j \in \{1,2,3\}$,

- $I_{\mathrm{sc}}$ ein Kurzschlussstrom der Leistungshalbleiterschalter ($T_1$, $T_2$, $T_3$) , und

- $\Delta I_g$ eine maximal zulässige Differenz $I_i$ - $I_j$ zwischen zwei Gateströmen $I_i$ und $I_j$, mit $i{\neq}j \in \{1,2,3\}$ ist.

4. Elektronische Schaltung nach einem der vorangehenden Ansprüche, **dadurch gekennzeichnet, dass**

- die synchron schaltbaren Leistungshalbleiterschalter ($T_1$, $T_2$, $T_3$) bipolare Transistoren mit isoliertem Gate (IGBT) sind.

5. Elektronische Schaltung nach einem der vorangehenden Ansprüche, **dadurch gekennzeichnet, dass**

- die synchron schaltbaren Leistungshalbleiterschalter ($T_1$, $T_2$, $T_3$) unipolare Feldeffekttransistoren mit isoliertem Gate (MOS-FET) sind.

6. Elektronische Schaltung nach Anspruch 4, **dadurch gekennzeichnet, dass**

- die erste elektrisch leitende Verbindung für jeden der IGBTs ($T_1$, $T_2$, $T_3$) einen Hilfsemitteranschluss ($H_1$, $H_2$, $H_3$) kontaktiert und

- parallel zu einer der ersten Induktivitäten ($L_{D1,1}$, $L_{D1,2}$, $L_{D1,3}$) ein Begrenzungswiderstand ($R_D$) vorgesehen ist.

7. Leistungshalbleitermodul, umfassend ein Modulgehäuse, **dadurch gekennzeichnet, dass**

- das Leistungshalbleitermodul eine elektronische Schaltung nach einem der Ansprüche 1 bis 5 umfasst.

8. Leistungshalbleitermodul nach Anspruch 7, **dadurch gekennzeichnet, dass**

- das das Leistungshalbleitermodul mindestens zwei Submodule umfasst und

- die zwei oder mehreren durch das Ansteuersignal synchron schaltbaren Leistungshalbleiterschalter ($T_1$, $T_2$, $T_3$) nicht alle im selben Submodul befinden.

Fig. 1

Fig. 2

Fig. 3a

Fig. 3b

Fig. 4

EP 1 480 339 A1

## EUROPÄISCHER RECHERCHENBERICHT

**Europäisches Patentamt**

Nummer der Anmeldung

EP 03 40 5343

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | DE 101 52 879 A (EUPEC GMBH & CO KG) 15. Mai 2003 (2003-05-15) * Abbildung 2 * --- | 1,4 | H03K17/16 |
| X | US 5 166 541 A (MORI HARUYOSHI) 24. November 1992 (1992-11-24) * Abbildung 2 * ----- | 1,4 | |

| RECHERCHIERTE SACHGEBIETE (Int.Cl.7) |
|---|
| H03K |

Der vorliegende Recherchenbericht wurde für alle Patentansprüche erstellt

| Recherchenort | Abschlußdatum der Recherche | Prüfer |
|---|---|---|
| MÜNCHEN | 20. Oktober 2003 | Brown, J |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument

    .........................................................................
& : Mitglied der gleichen Patentfamilie, übereinstimmendes
    Dokument

EPO FORM 1503 03.82 (P04C03)

11

**ANHANG ZUM EUROPÄISCHEN RECHERCHENBERICHT
ÜBER DIE EUROPÄISCHE PATENTANMELDUNG NR.**                EP 03 40 5343

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

20-10-2003

| Im Recherchenbericht angeführtes Patentdokument | Datum der Veröffentlichung | Mitglied(er) der Patentfamilie | Datum der Veröffentlichung |
|---|---|---|---|
| DE 10152879 A | 15-05-2003 | DE 10152879 A1 | 15-05-2003 |
| US 5166541 A | 24-11-1992 | JP 2855816 B2 | 10-02-1999 |
| | | JP 4083416 A | 17-03-1992 |
| | | CA 2047771 A1 | 26-01-1992 |
| | | DE 4124747 A1 | 30-01-1992 |
| | | FR 2665309 A1 | 31-01-1992 |
| | | KR 9411278 B1 | 03-12-1994 |

EPO FORM P0461

Für nähere Einzelheiten zu diesem Anhang : siehe Amtsblatt des Europäischen Patentamts, Nr.12/82